# EUROPEAN PATENT APPLICATION

(11) **EP 4 653 884 A1**
(43) Date of publication of application: **26.11.2025**
(21) Application number: 24744921.8
(22) Date of filing: 19.01.2024
(51) Int. Cl.: G01R 31/28

(54) **CONTACT INSPECTION APPARATUS**

(30) Priority: 20.01.2023 KR 20230008993; 13.12.2023 US 202318539028; 17.01.2024 CN 202410069091; 17.01.2024 CN 202420117211 U
(71) Applicant: Samsung Display Co., Ltd., Yongin-si, Gyeonggi-do 17113 (KR)
(72) Inventor: KIM, Byungsu, Yongin-si Gyeonggi-do 17113 (KR); KANG, Suk Ju, Yongin-si Gyeonggi-do 17113 (KR); LEE, Jung Min, Yongin-si Gyeonggi-do 17113 (KR); JUN, Eun Su, Yongin-si Gyeonggi-do 17113 (KR)
(74) Representative: Marks & Clerk LLP
(86) International application number: PCT/KR2024/000950
(87) International publication number: WO 2024/155142

(57) **Abstract**

A contact inspection device according to an embodiment of the present disclosure includes a support; a contact inspection module including an inspection terminal for contacting an target and performing an inspection; a crank module for combining the contact inspection module and the support and having a double crank structure; and a driving cylinder coupled to the support and the contact inspection module and moving the contact inspection module, wherein the driving cylinder pressurizes the contact inspection module in an oblique direction to move the same.

## Description

### [Background Art]

With the large-scale and automated production of products such as display devices, there are growing needs for inspection devices for detecting defects occurring during production.

In order for the inspection device contacting and inspecting the products to quickly and accurately find out the defects, the inspection device needs to quickly and accurately move and contact the products to be inspected.

### [Disclosure]

### [Technical Problem]

The present disclosure has been made in an effort to increase reliability of a contact inspection device.

### [Technical Solution]

An embodiment of the present disclosure provides a contact inspection device including: a support; a contact inspection module including an inspection terminal for contacting an inspection target and performing an inspection; a crank module for combining the contact inspection module and the support and having a double crank structure; and a driving cylinder coupled to the support and the contact inspection module and moving the contact inspection module, wherein the driving cylinder pressurizes the contact inspection module in an oblique direction to move the same.

The driving cylinder may be coupled to the support in a rotatable way.

The driving cylinder may be coupled to the contact inspection module in a rotatable way.

The driving cylinder may include a piston rod for obliquely moving back and forth with respect to the contact inspection module, and the contact inspection module may obliquely move when the piston rod moves back and forth.

The support may include a first support coupled to the crank module, and a second support coupled to the first support with an angle therebetween.

The contact inspection module may be coupled to the first support, and the driving cylinder may be coupled to the second support.

The crank module may include two pairs of connecting rods with a predetermined length, a plurality of first fasteners for combining the respective connecting rods to the support in a rotatable way, and a plurality of second fasteners for combining the respective connecting rods to the contact inspection module in a rotatable way.

The respective first fasteners may include a bolt and a bearing, the bolt may include a head, a shank coupled to the bearing, and a thread fixed and coupled to the support, and the bearing may be coupled to the connecting rod in a rotatable way.

The respective second fasteners may include a bolt and a bearing, the bolt may include a head, a shank coupled to the bearing, and a thread fixed and coupled to the contact inspection module, and the bearing may be coupled to the connecting rod in a rotatable way.

The contact inspection device may further include a height adjusting screw for adjusting a height of the inspection terminal.

Another embodiment of the present disclosure provides a contact inspection device including: horizontal and vertical supports coupled to each other; a contact inspection module including an inspection terminal for contacting an inspection target and performing an inspection; a crank module coupled to the contact inspection module and the horizontal support and having a double crank structure; and a driving cylinder including a piston rod moving back and forth in an oblique direction, of which one end is coupled to the contact inspection module in a rotatable way, and coupled to the vertical support in a rotatable way.

The crank module may include two pairs of connecting rods with a predetermined length, a plurality of first fasteners for combining the respective connecting rods to the support in a rotatable way, and a plurality of second fasteners for combining the respective connecting rods to the contact inspection module in a rotatable way.

The respective first fasteners may include a bolt and a bearing, the bolt may include a head, a shank coupled to the bearing, and a thread fixed and coupled to the horizontal support, and the bearing may be coupled to the connecting rod in a rotatable way.

The respective second fasteners may include a bolt and a bearing, the bolt may include a head, a shank coupled to the bearing, and a thread fixed and coupled to the contact inspection module, and the bearing may be coupled to the connecting rod in a rotatable way.

The contact inspection device may further include a height adjusting screw for adjusting a height of the inspection terminal.

Another embodiment of the present disclosure provides a contact inspection device including: a support; a contact inspection module including an inspection terminal for contacting an inspection target and performing an inspection; a driving member for obliquely applying a force to the contact inspection module; and a horizontality maintaining member for maintaining parallel with the support while the contact inspection module moves.

The driving member may be coupled to the contact inspection module in a rotatable way, and the driving member may include a piston rod obliquely moving back and forth with respect to the contact inspection module and having an end coupled to the contact inspection module.

The horizontality maintaining member may include two pairs of connecting rods with a predetermined length, a plurality of first fasteners for combining the respective connecting rods to the support in a rotatable way, and a plurality of second fasteners for combining the respective connecting rods to the contact inspection module in a rotatable way.

The respective first fasteners may include a bolt and a bearing, the bolt may include a head, a shank coupled to the bearing, and a thread fixed and coupled to the support, and the bearing may be coupled to the connecting rod in a rotatable way.

The respective second fasteners may include a bolt and a bearing, the bolt may include a head, a shank coupled to the bearing, and a thread fixed and coupled to the contact inspection module, and the bearing may be coupled to the connecting rod in a rotatable way.

### [Advantageous Effects]

As described above, reliability of the contact inspection device may be increased.

### [Description of Drawings]

FIG. 1 shows a perspective view of a contact inspection device according to an embodiment of the present disclosure.
FIG. 2 is an enlarged diagram of a portion of the contact inspection device shown in FIG. 1.
FIG. 3 and FIG. 4 show lateral views of the contact inspection device shown in FIG. 1, showing an opened state and a closed state, respectively.
FIG. 5 shows operations of the contact inspection device shown in FIG. 1.

### [Mode for Invention]

Hereinafter, with reference to the attached drawings, various embodiments of the present disclosure will be described in detail. The present disclosure may be implemented in many different forms and is not limited to the embodiments described herein. Embodiments are merely provided to enable those skilled in the art may easily understand the present disclosure. Identical or similar components are assigned the same reference numerals throughout the specification.

Additionally, when a part of a layer, membrane, region, or plate is said to be "on" another part, this includes not only cases where it is "directly on" another part, but also cases where there is another part in between. In contrast, when an element is referred to as being "directly above" another element, there are no intervening elements present.

The terms "first," "second," "third," and the like are used for various components, parts, areas, layers, parts, and the like, but they are not limited by these modifiers. These terms are used to distinguish one component, part, area, layer, or portion from another component, part, area, layer, or portion. Thus, a "first component," "part," "area," "layer," or "portion" may also be referred to as a second component, part, area, layer, or portion without departing from the spirit and scope of the present invention.

The terms used herein are for the purpose of describing particular embodiments only and are not intended to limit the invention. Unless specifically referring to a number, references herein include both the singular and plural. For example, "a component" or "one component" means "at least one component" unless otherwise noted. "At least one" shall not be construed to mean only one. "Or" means "and/or". As used herein, the expression "and/or" includes any combination of one or more of the things listed. The expression "includes" or "has" any feature, area, integer, step, behavior, component, part, etc. means that it may include other features, areas, integers, steps, behaviors, components, parts, etc. in addition to that part.

In addition, spatial relationship terms such as "below," "under," and "above" may be used to indicate the relationship of one part of the drawing to another part of the drawing. These spatial relationship terms can refer to other locations or orientations in addition to the location or orientation of the device shown in the drawing. For example, a part shown in a drawing as being "below" or "under" something may be reversed to being "above" that part when the device is flipped. Therefore, for example, "below" and "under" can refer to either up or down, depending on the orientation shown in the drawing.

Unless otherwise noted, all terms used herein (including technical and scientific terms) have the same meaning as commonly understood by those skilled in the art to which this invention belongs. Terms, including commonly used dictionary-defined terms, shall be construed as having a meaning consistent with their meaning in the relevant technical field and/or in this specification, and shall not be construed in an idealized or overly strict sense unless expressly stated herein.

The embodiments described herein are not limited to the specific shape of the areas shown in the drawings, and include deviations in shape resulting from the manufacturing process. For example, areas shown or described as flat may have generally rough or nonlinear characteristics. Also, angles depicted as pointed may be rounded. Therefore, the areas shown in the drawings are schematic and are not intended to show the exact shape of the areas, nor are they intended to limit the scope of the invention.

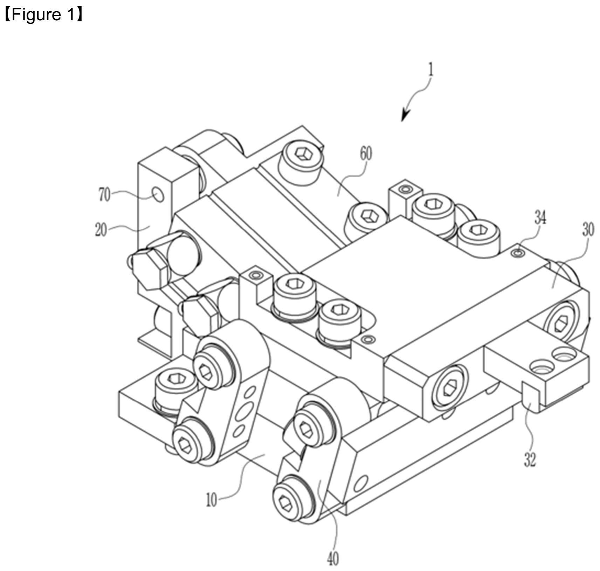

A contact inspection device according to an embodiment of the present disclosure will now be described in detail with reference to FIG. 1 to FIG. 5.

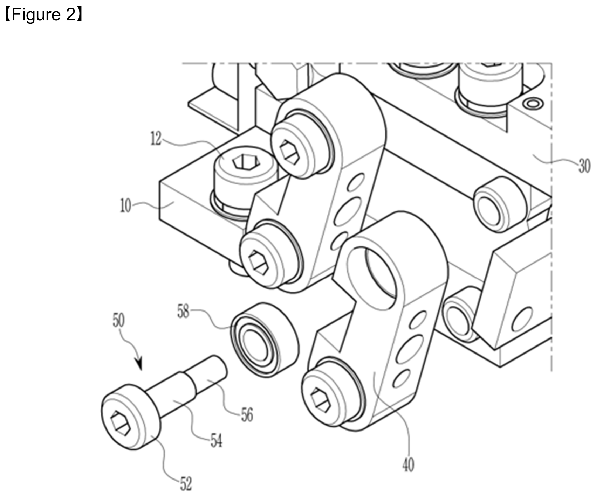

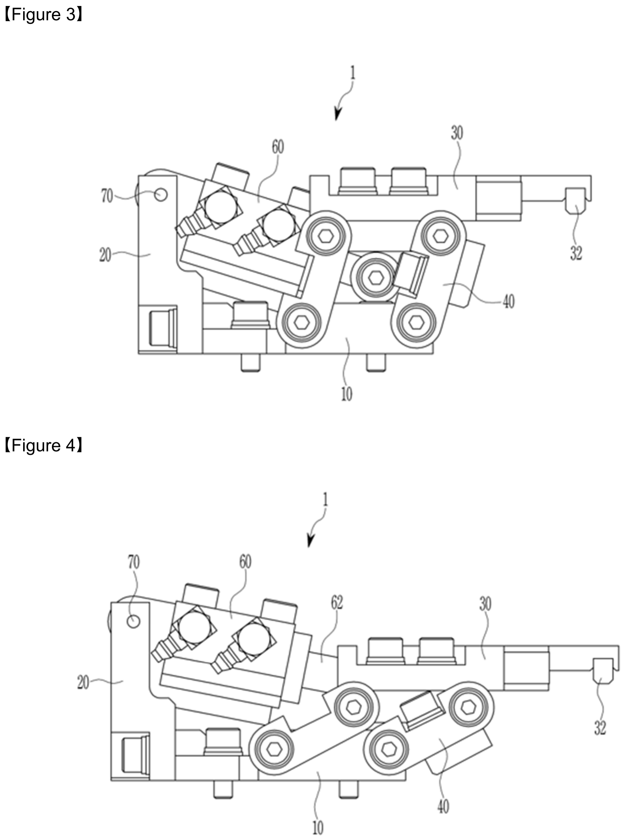

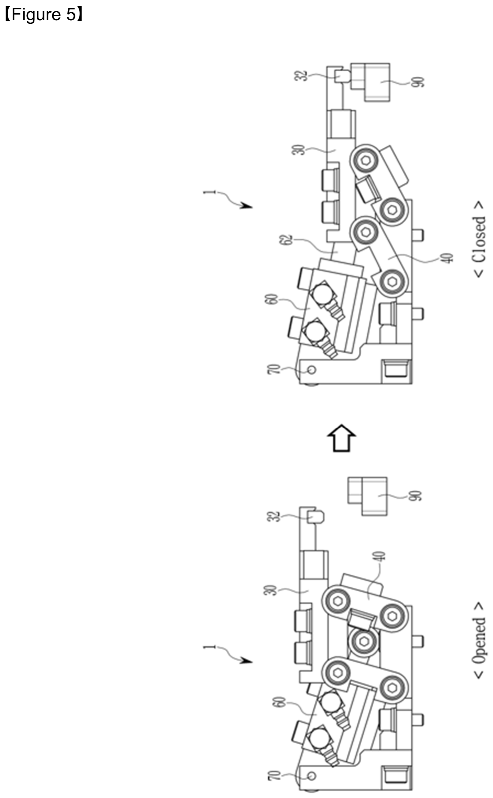

FIG. 1 shows a perspective view of a contact inspection device according to an embodiment of the present disclosure, and FIG. 2 is an enlarged diagram of a portion of the contact inspection device shown in FIG. 1. FIG. 3 and FIG. 4 show lateral views of the contact inspection device shown in FIG. 1, with FIG. 3 showing an opened state and FIG. 4 showing a closed state. FIG. 5 shows operations of the contact inspection device shown in FIG. 1.

Referring to FIG. 1, a contact inspection device according to an embodiment may include supports 10 and 20, a contact inspection module 30, a crank module 40, and a driving cylinder 60.

The supports 10 and 20 may include a horizontal support 10 and a vertical support 20 coupled to the horizontal support 10, and the horizontal support 10 may be fixed on a ground or a table through a fixing member 12. The vertical support 20 and the horizontal support 10 may make a right angle, and but not being limited thereto, for example, they may make various angles.

The contact inspection module 30 is configured to contact and inspect a target 90 to be inspected, for example, a display device module, and may include an inspection terminal 32 contacting the target. The contact inspection module 30 may include various electrical circuits for inspection. The contact inspection module 30 may also include a height adjusting screw 34 for adjusting the height of the inspection terminal 32.

The contact inspection module 30 is coupled to the driving cylinder 60. The driving cylinder 60 includes a piston rod 62 that can move back and forth using hydraulic pressure, etc., and has an end rotatably coupled to the contact inspection module 30, for example, through a bearing, to force the contact inspection module 30 to move. As shown in the figures, the piston rod 62 may not be parallel to the contact inspection module 30 but may be oblique thereto.

The driving cylinder 60 may be obliquely coupled to the vertical support 20, for example, through a shaft 70 along with a bearing, etc., such that the driving cylinder 60 is rotatable around the shaft 70. Similarly, the piston rod 62 may be rotatable around a shaft of the contact inspection module 30, the shaft being parallel to the shaft 70 at the vertical support 20.

The contact inspection module 30 is coupled to the horizontal support 10 through the crank module 40. Referring to FIG. 2, the crank module 40 has a double crank structure including two pairs of rod members or connecting rods 42 and four pairs of fastening members or fasteners 50. The connecting rods 42 may have substantially the same length and may be arranged in parallel to each other. Each of the connecting rods 42 may be rotatably coupled to both the horizontal support 10 and the contact inspection module 30 through a pair of the fasteners 50. In detail, each fastener 50 may include a bolt including a head 52, a shank 54, and a thread 56. The thread 56 of the bolt may be fixed to either of the contact inspection module 30 or the horizontal support 10, and the bolt may be rotatably coupled to one of the connecting rods 42 through a bearing 58 coupled to the shank 54. Therefore, when the contact inspection module 30 moves, the connecting rods 42 may rotate around the shafts of the bolts coupled to the horizontal support 10 and the shafts of the bolts coupled to the contact inspection module 30 so that the contact inspection module 30 may maintain its horizontality.

An operation of the contact inspection device according to an embodiment of the present disclosure will now be described in detail with reference to FIG. 5.

Referring to FIG. 5, a standby state before starting inspection is referred to as an "opened" state in which the piston rod 62 of the driving cylinder 60 has moved toward a main body of the driving cylinder 60, that is, a length of a portion of the piston rod 62 exposed to the outside (hereinafter, referred to as an "exposed length") is short. In this instance, the contact inspection module 30 may maintain its horizontality or parallelism to the horizontal support 10 due to the constraint by the crank module 40, while it may be oblique to the piston rod 62 of the driving cylinder 60.

When a target 90 to be inspected such as a display device module arrives, the inspection terminal 32 of the contact inspection module 30 is allowed to contact and perform inspection on the target 90. The target 90 may be disposed lower than and external to the inspection terminal 32.

To this end, when hydraulic pressure is applied in the opened state to push the piston rod 62 to move outwardly, and the movement of the piston rod 62 forces the contact inspection module 30, which is rotatably coupled to the piston rod 62, to move outwardly and downwardly, thereby approaching the target 90. As the piston rod 62 is coupled to the contact inspection module 30 in a slanted way, the force applied by the piston rod 62 to the contact inspection module 30 is directed in an oblique direction. Due to the constraint by the double crank structure of the crank module 40 coupled to the contact inspection module 30 as described above, the contact inspection module 30 maintains its horizontality during the movement as well as before and after the movement.

The contact inspection module 30 moves until the inspection terminal 32 of the contact inspection module 30 contacts the target 90 and then it stops to enter the "closed" state. In this state, the target 90 is inspected through the inspection terminal 32.

In the closed state, when the vertical position of the inspection terminal 32 is incorrect, the vertical position of the inspection terminal 32 may be adjusted using the height adjusting member 34.

In the above embodiments, the contact inspection module 30 may approach and apply a force to the target 90 in an inclined direction while maintaining its horizontality, and thus the inspection terminal 32 may contact the target 90 with uniformly distributed pressure, thereby increasing the reliability of inspection.

As an example, in a display device module where a plurality of terminals to be contacted by the inspection terminal 32 may be arranged in multiple rows, the pressure on different rows of the terminals applied by the inspection terminal 32 may be different, which may cause errors in inspection results. However, in the present embodiment, the stationary horizontality of the contact inspection module 30 may enable all the rows of the terminals to be applied with equal pressure, thereby increasing the reliability of the inspection.

In the present embodiment, the piston rod 62 of the driving cylinder 60 applies an oblique force to the contact inspect member 30 to move so that the force on the terminal(s) of the target 90 by the inspection terminal 32 of the contact inspect member 30 may be greater than that in the case of pushing the contact inspect member 30 with a horizontal force parallel to the contact inspect member 30 to move, thereby providing a stable contact to the target 90 during inspection.

While this disclosure has been described in connection with what is presently considered to be practical embodiments, it is to be understood that the disclosure is not limited to the disclosed embodiments. Embodiments are merely provided to enable those skilled in the art to easily understand and practice the present invention.

Although the present invention has been specifically described with reference to embodiments, it will be apparent to those skilled in the art that various changes in form and specific content may be made without departing from the concept and scope of the present invention as defined in the following claims.

## Claims

1. A contact inspection device comprising:
a support;
a contact inspection module including an inspection terminal configured to contact and inspect a target;
a crank module coupling the contact inspection module with the support and having a double crank structure; and
a driving cylinder coupled to the support and the contact inspection module, the driving cylinder configured to force the contact inspection module to move,
wherein the driving cylinder is configured to apply a force to the contact inspection module in an oblique direction to move.

2. The contact inspection device of claim 1, wherein
the driving cylinder is coupled to the support in a rotatable way.

3. The contact inspection device of claim 1, wherein
the driving cylinder is coupled to the contact inspection module in a rotatable way.

4. The contact inspection device of claim 1, wherein
the driving cylinder comprises a piston rod being movable back and forth in a direction oblique to the contact inspection module, and
the contact inspection module moves obliquely according to the oblique movement of the piston rod.

5. The contact inspection device of claim 1, wherein
the support comprises:
a first support coupled to the crank module; and
a second support coupled to the first support with making an angle.

6. The contact inspection device of claim 5, wherein
the contact inspection module is coupled to the first support, and
the driving cylinder is coupled to the second support.

7. The contact inspection device of claim 1, wherein
the crank module comprises:
two pairs of connecting rods having a substantially equal length;
a plurality of first fasteners coupling the respective connecting rods to the support in a rotatable way; and
a plurality of second fasteners coupling the respective connecting rods to the contact inspection module in a rotatable way.

8. The contact inspection device of claim 7, wherein
each of the first fasteners comprises a bolt and a bearing,
the bolt comprises:
a head;
a shank coupled to the bearing; and
a thread fixed to the support, and
the bearing is coupled to one of the connecting rods in a rotatable way.

9. The contact inspection device of claim 7, wherein
each of the second fasteners comprises a bolt and a bearing,
the bolt comprises:
a head;
a shank coupled to the bearing; and
a thread fixed to the contact inspection module, and
the bearing is coupled to one of the connecting rods in a rotatable way.

10. The contact inspection device of claim 1, wherein
the contact inspection device further comprises a height adjusting screw adjusting a vertical position of the inspection terminal.

11. A contact inspection device comprising:
horizontal and vertical supports coupled to each other;
a contact inspection module including an inspection terminal configured to contact and inspect a target;
a crank module coupled to the contact inspection module and the horizontal support and having a double crank structure; and
a driving cylinder comprising a piston rod that is movable back and forth in an oblique direction and has an end rotatably coupled to the contact inspection module, the driving cylinder coupled to the vertical support in a rotatable way.

12. The contact inspection device of claim 11, wherein
the crank module comprises:
two pairs of connecting rods having a substantially equal length,
a plurality of first fasteners, each of the plurality of first fasteners coupling one of the connecting rods to one of the horizontal and vertical supports in a rotatable way, and
a plurality of second fasteners, each of the plurality of second fasteners coupling one of the connecting rods to the contact inspection module in a rotatable way.

13. The contact inspection device of claim 12, wherein
each of the first fasteners comprises a bolt and a bearing,
the bolt comprises
a head;
a shank coupled to the bearing; and
a thread fixed to the horizontal support, and
the bearing is coupled to one of the connecting rods in a rotatable way.

14. The contact inspection device of claim 12, wherein
each of the second fasteners comprises a bolt and a bearing,
the bolt comprises:
a head;
a shank coupled to the bearing; and
a thread fixed to the contact inspection module, and
the bearing is coupled to one of the connecting rods in a rotatable way.

15. The contact inspection device of claim 11, wherein
the contact inspection device further comprises a height adjusting screw for adjusting a vertical position of the inspection terminal.

16. A contact inspection device comprising:
a support;
a contact inspection module including an inspection terminal configured to contact and inspect a target;
a driving member configured to apply an oblique force to the contact inspection module to move; and
a horizontality maintaining member configured to maintain the contact inspection module being substantially parallel with the support during the movement of the contact inspection module.

17. The contact inspection device of claim 16, wherein
the driving member is coupled to the contact inspection module in a rotatable way, and
the driving member comprises a piston rod that is movable back and forth in a direction oblique to the contact inspection module and having an end coupled to the contact inspection module.

18. The contact inspection device of claim 16, wherein
the horizontality maintaining member comprises:
two pairs of connecting rods having a substantially equal length;
a plurality of first fasteners coupling the respective connecting rods to the support in a rotatable way, and
a plurality of second fasteners coupling the respective connecting rods to the contact inspection module in a rotatable way.

19. The contact inspection device of claim 18, wherein
each of the respective first fasteners comprises a bolt and a bearing,
the bolt comprises
a head;
a shank coupled to the bearing; and
a thread fixed to the support, and
the bearing is coupled to one of the connecting rods in a rotatable way.

20. The contact inspection device of claim 18, wherein
each of the second fasteners comprises a bolt and a bearing,
the bolt comprises:
a head;
a shank coupled to the bearing; and
a thread fixed to the contact inspection module, and
the bearing is coupled to one of the connecting rods in a rotatable way.
